# EUROPÄISCHE PATENTSCHRIFT

(11) **EP 2 601 716 B1**
(45) Veröffentlichungstag und Bekanntmachung des Hinweises auf die Patenterteilung: **11.03.2015**
(21) Anmeldenummer: 11751566.8
(22) Anmeldetag: 05.08.2011
(51) Int. Cl.: H01T 1/14, H01H 37/76, H05K 1/02

(54) **THERMISCHE ÜBERLASTSCHUTZANORDNUNG**
THERMAL OVERLOAD PROTECTION ARRANGEMENT
DISPOSITIF DE PROTECTION THERMIQUE CONTRE LES SURCHARGES

(30) Priorität: 08.10.2010 DE 102010038066; 06.08.2010 DE 102010036907
(43) Veröffentlichungstag der Anmeldung: 12.06.2013
(73) Patentinhaber: Phoenix Contact GmbH & Co. KG, 32825 Blomberg (DE)
(72) Erfinder: MEYER, Thomas, 31868 Ottenstein (DE); PFÖRTNER, Steffen, 31832 Springe (DE)
(74) Vertreter: Michalski Hüttermann & Partner Patentanwälte mbB
(86) Internationale Anmeldenummer: PCT/EP2011/063548
(87) Internationale Veröffentlichungsnummer: WO 2012/017086

(56) Entgegenhaltungen:
- EP-B1- 0 898 802
- DE-A1-102005 045 778
- DE-B3-102009 036 578
- US-A- 5 831 507
- US-A1- 2009 027 156

## Beschreibung

Die Erfindung geht aus von einer thermischen Überlastschutzanordnung gemäß dem Oberbegriff des Anspruchs 1. Die Erfindung geht weiterhin aus von einem entsprechenden Verfahren gemäß dem Oberbegriff des Anspruchs 8.

Die Überbeanspruchung von elektronischen Bauelementen kann dazu führen, dass diese außerhalb eines Nennbetriebsbereiches arbeiten. Dabei führt ein zum Beispiel durch eine reduzierte Isolationsfestigkeit des Bauelements hervorgerufene Leistungsumsatz an einem geschädigten Bauelement zu einer erhöhten Erwärmung. Wird eine Erwärmung des Bauelements über eine Zulässigkeitsschwelle hinaus nicht verhindert, kann dies zum Beispiel zur Schädigung umgebender Materialien, Entstehung von Rauchgasen oder zu einer Brandgefahr führen.

Es ist daher üblich, einem solchen Bauelement eine Temperatursicherung zuzuordnen um eine Abschaltung bei unzulässiger Erwärmung zu ermöglichen. Aufgrund der begrenzten thermischen Ankopplungsmöglichkeit ist diese Anordnung für sehr schnelle Erwärmungsvorgänge jedoch nicht geeignet.

Bei Überspannungsschutzgeräten ist es üblich, die verwendeten Überspannungsschutzbauelemente insbesondere Varistoren mit thermisch aktivierten Abschalteinrichtungen auszustatten.

Eine thermische Überlastschutzanordnung zum Schutz eines auf einer Leiterplatte mit Leiterbahnen angeordneten leistungselektronischen Bauelements ist aus der Offenlegungsschrift DE 10 2005 045 778 A1 bekannt, bei der die Überlastschutzanordnung mehrere, je eine Leiterbahn einer Leiterplatte mit einem zugehörigen Anschlussbereich eines Leiterstegs elektrisch kontaktierende und bei thermischer Überlast schmelzende Lotverbindungen und eine Einrichtung mit Temperatursensor und einem Öffnungselement zum Lösen mindestens einer dieser Verbindungen aufweist.

Durch die räumliche Trennung von Bauelement und Überlastschutzanordnung ergibt sich einerseits eine gewisse Trägheit des Systems, andererseits ein relativ großer Platzbedarf.

Aus der US 2009/027156 A1 ist eine Vorrichtung zum Schutz einer elektronischen Schaltung mit einem auf einer Leiterplatte mit Leiterbahnen angeordneten elektrischen Bauelement bekannt. Die Vorrichtung weist mehrere je eine der Leiterbahnen mit einem zugehörigen Anschluss des elektrischen Bauelements elektrisch kontaktierende und bei Überlast des Bauelements schmelzende Lotverbindungen und eine Federeinrichtung zum Lösen dieser Verbindungen auf, wobei die Federeinrichtung das Bauelement gegenüber der Leiterplatte vorspannt und -ausgelöst durch ein Aufschmelzen der Lotverbindungen- das Bauelement von den Leiterbahnen räumlich separiert. Die EP 0 898 802 B1 zeigt eine ganz ähnliche Vorrichtung.

Der Erfindung liegt die Aufgabe zu Grunde, eine Überlastschutzanordnung und ein Verfahren zum Schutz von Bauelementen anzugeben, welche beziehungsweise welches einen schnellen und zuverlässigen Schutzmechanismus aufweist und mit einem möglichst geringen Bauraumbedarf auf einer Trägereinrichtung verbunden ist.

Die Lösung der Aufgabe erfolgt erfindungsgemäß durch die Merkmale der unabhängigen Ansprüche 1 und 8. Vorteilhafte Ausgestaltungen der Erfindung sind in den Unteransprüchen angegeben.

Bei der erfindungsgemäßen Überlastschutzanordnung ist die Abtrennvorrichtung eine das Bauelement gegenüber der Trägereinrichtung - zumindest bei Erwärmung - vorspannende Abtrennvorrichtung zur räumlichen Separation des Bauelements von mindestens einem der Stromführungselemente, die bei Aufschmelzen der Lotverbindungen auslöst. Das vorzugsweise elektronische Bauelement wird auf Stromführungselementen der Trägereinrichtung, zum Beispiel Leiterbahnen einer Leiterplatte, mit einem niedrigschmelzenden Lot befestigt. Die Schmelztemperatur dieses Lots liegt zum Beispiel bei 150°C. Kommt es zu einer thermischen Beanspruchung des Bauelements, so leiten die Anschlüsse Wärme zu den Lotverbindungen. Geht die thermische Beanspruchung über die Schmelztemperatur des Lots hinaus, so schmelzen die Lotverbindungen auf. Da die Abtrennvorrichtung das Bauelement gegenüber der Trägereinrichtung vorspannt, löst das Aufschmelzen der Lotverbindungen die Abtrennvorrichtung umgehend aus, wobei die Abtrennvorrichtung das Bauelement durch dessen Verlagerung dauerhaft von den Stromführungselementen räumlichen separiert. Dadurch dass kein separates Bauteil zum Öffnen eines Stromkreises genutzt wird, ergibt sich eine Verringerung des benötigten Bauraums. Weiterhin kommt es durch die unmittelbar mit dem Bauelement verbundenen Auslöse- und Trennelemente zu einer schnellen Abtrennung.

Erfindungsgemäß ist vorgesehen, dass die Abtrennvorrichtung eine Abtrennvorrichtung für ein Verlagern des Bauelements zu dessen Separation von mindestens einem der Stromführungselemente entlang der Oberfläche der Trägereinrichtung ist. Eine derartige Abtrennvorrichtung bewegt das Bauelement zur Separation im Wesentlichen entlang der Oberfläche der Trägereinrichtung, insbesondere quer zu einer gedachten Verbindungslinie zwischen zwei über das Bauelement elektrisch aneinander gekoppelte Lotverbindungen.

Gemäß einer bevorzugten Ausführungsform der Erfindung ist vorgesehen, dass die Abtrennvorrichtung einen Aktor aufweist, der als (a) Federeinrichtung und/oder (b) Einrichtung aus intumeszentem Material und/oder (c) Einrichtung aus Formgedächtnismaterial und/oder (d) Einrichtung aus einem seine Form chemisch verändernden Material ausgebildet ist. Ein derartiger Aktor spannt das Bauelement gegenüber der Trägereinrichtung generell oder zumindest bei Erwärmung vor.

Die Alternativen (b) bis (d) haben den Vorteil, dass die Lotverbindungen beziehungsweise die gesamte Abtrennvorrichtung im Nennbetrieb (Normalbetrieb) kraftfrei ist, da eine entsprechende Kraft erst nach dem Auslösen der Abtrennvorrichtung mit Aktor gemäß einer der Alternativen (b) bis (d) auftritt.

Bei einer dieser Ausführungsformen weist die Abtrennvorrichtung eine Federeinrichtung auf. Diese ist insbesondere als Druckfeder ausgebildet. Optional kann dabei das Bauelement oder die Federeinrichtung durch einen niedrigschmelzenden Kunststoff fixiert werden um die mechanische Belastung der Lotverbindungen zu minimieren. Die Schmelztemperatur der Lotverbindung liegt dabei über der des Schmelzkunststoffs. Wird das Niedrigtemperaturlot mittels Flussmittel so ausgeführt, dass es aufgrund der Oberflächenspannung bei einer Abtrennung oberhalb der Schmelztemperatur sicher auf den Lotflächen verbleibt, kann die Schmelztemperatur des zur Fixierung des Bauelements oder Federelements verwendeten Schmelzkunststoffs über der Lotschmelztemperatur liegen.

Insbesondere ist vorgesehen, dass die Überlastschutzanordnung weiterhin eine Fangeinrichtung aufweist, die das separierte Bauelement - alleine oder zusammen mit der Abtrennvorrichtung - in einer definierten Position fixiert. Um ein unkontrolliertes Bewegen des Bauelements in einem die Trägereinrichtung aufweisenden Gerät nach der Abtrennung/Separation zu vermeiden, ist diese Fangeinrichtung vorgesehen. Vorteilhafterweise kann die Fangeinrichtung durch einen die Trägereinrichtung umgebenden Gehäuseteil gebildet werden. Das Fixieren des Bauelements in der Fangeinrichtung ist bevorzugt ein lösbares Fixieren.

Generell ist die Abtrennvorrichtung und insbesondere deren Aktor neben dem Bauelement, oberhalb des Bauelements, unterhalb des Bauelements oder sogar unterhalb der Trägereinrichtung angeordnet. Mit Vorteil ist die Abtrennvorrichtung und insbesondere der Aktor der Abtrennvorrichtung jedoch zwischen Trägereinrichtung und Bauelement angeordnet. Eine derartige Überlastschutzanordnung ist besonders platzsparend ausgebildet. Besonders bevorzugt ist der Aktor zwischen der Trägereinrichtung und dem Schwerpunkt des Bauelements angeordnet. Gemäß einer bevorzugten Ausführungsform der Erfindung ist vorgesehen, dass die Abtrennvorrichtung - insbesondere bezogen auf die Oberfläche der Trägereinrichtung - zwischen zumindest zwei der Lotverbindungen angeordnet ist.

Gemäß einer Weiterbildung der Erfindung ist weiterhin vorgesehen, dass die Überlastschutzanordnung das Bauelement und/oder die Trägereinrichtung mit aufweist. Generell kann das Bauelement ein beliebiges Bauelement sein. Bevorzugt ist es jedoch als ein oberflächenmontierbares Bauelement (SMD-Bauelement) ausgebildet (SMD: surface-mounted device).

Vor einem Reflow-Lötprozess (Wiederaufschmelz-Lötprozess) der Oberflächenmontage erfolgt zum Beispiel nur eine Teilbestückung mit einigen der Komponenten der Überlastschutzanordnung. Weitere Komponenten werden erst nach dem Reflow-Lötprozess angebracht. Diese Ausführungsvariante ist für alle zuvor genannten Arten (a) bis (d) von Aktoren möglich.

Weiterhin ist mit Vorteil vorgesehen, dass die Überlastschutzanordnung den als Federeinrichtung ausgebildeten Aktor, das SMD-Bauelement und die Lotverbindungen aufweist und als oberflächenmontierbare Anordnung ausgebildet ist. Alternativ zu der Teilbestückung vor dem Reflow-Prozess ist es bei einer oberflächenmontierbaren Anordnung mit als Federeinrichtung ausgebildetem Aktor möglich, dass die gesamte Anordnung Reflow-Prozessfähig ist. Je nach Herstellungsprozess der Anordnung wird dazu entweder (i) die vorgespannte Federeinrichtung während des Reflow-Prozesses blockiert und danach die Federeinrichtung durch entfernen des Blockierelements freigegeben oder (ii) die Federeinrichtung ist während des Reflow-Prozesses kraftfrei und die entsprechende Vorspannung wird erst nach dem Reflow-Prozess aufgebracht.

Bei dem erfindungsgemäßen Verfahren ist vorgesehen, dass mehrere, je eines der Stromführungselemente mit einem zugehörigen Anschluss des Bauelements elektrisch kontaktierende und bei Überlast des Bauelements schmelzende Lotverbindungen und eine Abtrennvorrichtung zum Lösen dieser Verbindungen vorgesehen sind, wobei die Abtrennvorrichtung das Bauelement gegenüber der Trägereinrichtung - zumindest bei Erwärmung - vorspannt und das Bauelement bei Aufschmelzen der Lotverbindungen räumlich von den Stromführungselementen separiert.

Nachfolgend wird die Erfindung unter Bezugnahme auf die anliegenden Zeichnungen anhand bevorzugter Ausführungsformen näher erläutert.

Es zeigen
Fig. 1 ein elektronisches Bauelement und eine nichterfindungsgemäße thermische Überlastschutzanordnung im unausgelösten Betriebszustand,
Fig. 2 das Bauelement und die thermische Überlastschutzanordnung der Figur 1 im ausgelösten Betriebszustand,
Fig. 3 ein elektronisches Bauelement und eine thermische Überlastschutzanordnung im unausgelösten Betriebszustand gemäß einer Ausführungsform der Erfindung, und
Fig. 4 das Bauelement und die thermische Überlastschutzanordnung der Figur 3 im ausgelösten Betriebszustand.

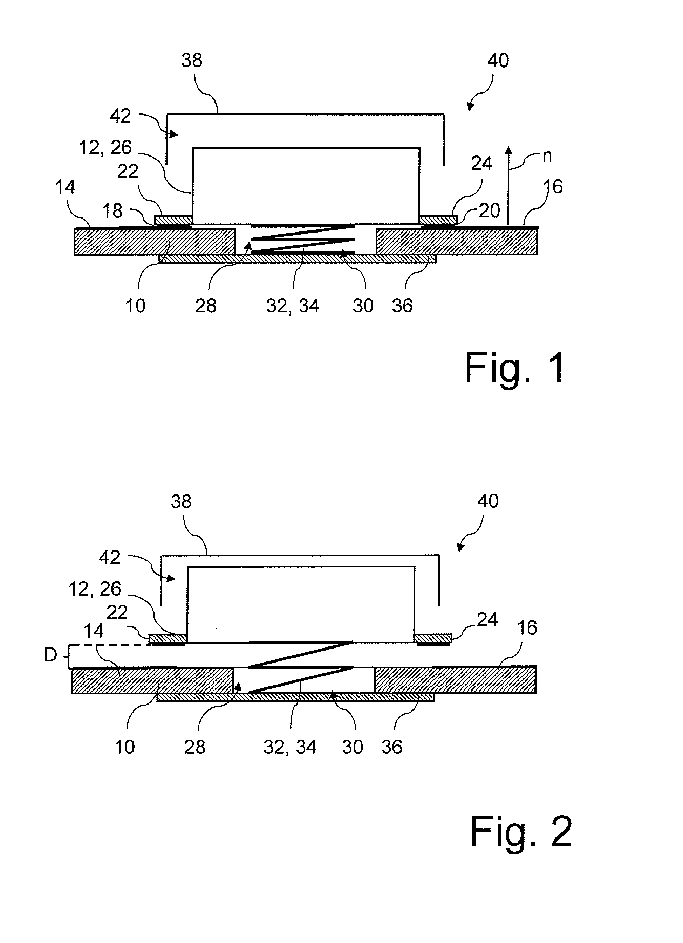

Die Figur 1 zeigt in Seitenansicht einen Ausschnitt einer als Platine ausgebildeten Trägereinrichtung 10 für die Montage und elektrische Kontaktierung von elektrischen Bauelementen 12, insbesondere elektronischen Bauelementen. Dazu weist die Trägereinrichtung 10 auf ihrer Oberseite als Leiterbahnen ausgebildete Stromführungselemente 14, 16 auf, von denen zwei Stromführungselemente 14, 16 dargestellt sind. Diese kontaktieren jeweils über eine Lotverbindung 18, 20 mit niedrigschmelzendem Lot je einen zugeordneten Anschluss 22, 24 eines elektronischen Bauelements 12. Dieses ist als SMD-Bauelement 26 ausgeführt. Ein Bereich der Trägereinrichtung 10 unterhalb dieses Bauelements 12 weist eine als Durchbruch ausgebildete Ausnehmung 28 auf. In der Ausnehmung 28 ist eine Abtrennvorrichtung 30 mit einem als Federeinrichtung 32 ausgebildeten Aktor 34 angeordnet, die das Bauelement 12 gegenüber einer Grundplatte 36 der Trägereinrichtung 10 "auf Druck" vorspannt (Druckfeder).

Die in Fig. 1 gezeigte Situation zeigt das Bauelement 12 auf der Trägereinrichtung 10 in seinem Betriebszustand. Oberhalb, also in Richtung der Oberflächennormale auf der das Bauelement tragenden Seite der Trägereinrichtung 10 ist eine Fangeinrichtung 38 angeordnet, deren Funktion im Rahmen der Beschreibung der Fig. 2 diskutiert wird.

Die Anordnung der Lotverbindungen 18, 20 und der Abtrennvorrichtung 30 relativ zu der Trägereinrichtung 10 und dem Bauelement 12 ist die thermische Überlastschutzanordnung 40. Die thermische Überlastschutzanordnung 40 ist eine thermische Überlastschutzanordnung 40 zum Schutz des auf der Trägereinrichtung 10 angeordneten elektrischen Bauelements 12. In der in den Figuren 1 bis 4 gezeigten Ausführungsbeispielen weist diese Überlastschutzanordnung 40 weiterhin auch die Fangeinrichtung 38 auf.

Es ergibt sich folgende Funktion der Überlastschutzanordnung 40: Die Abtrennvorrichtung 30 spannt das Bauelement 12 gegenüber der Trägereinrichtung 10 vor, sodass sich bei erhöhter thermischer Belastung des Bauelements 12 auch die das Bauelement 12 auf der Trägereinrichtung 10 haltenden Lotverbindungen erwärmen. Überschreitet deren Temperatur den Schmelzpunkt des Lots, so schmelzen die Lotverbindungen 18, 20 auf und das Bauteil 12 wird mittels des Aktors 34 der Abtrennvorrichtung 30 in Richtung der Oberflächennormale (Pfeil n) von der Trägereinrichtung und insbesondere deren Stromführungselementen 14, 16 separiert. Diese Situation ist in Fig. 2 dargestellt.

Um das Bauelement nach dem Abtrennvorgang in einer definierten Position zu halten, ist oberhalb des Bauelements 12 die fangkorbartige Fangeinrichtung 38 angeordnet. Der Aktor 34 der Abtrenneinrichtung 30 verlagert beim Abtrennvorgang (Separationsvorgang) das Bauelement 12 in einen Aufnahmebereich 42 der Fangeinrichtung 38 und fixiert das Bauelement dort durch seine Restspannung. Die Position des Bauelements 12 im Aufnahmebereich 42 der Fangeinrichtung 32 gewährleistet einen hinreichenden Abstand D zu den Stromführungselementen 14, 16 der Trägereinrichtung 10, sodass keine Funkenstrecken entstehen können.

Die Erwärmung des elektronischen Bauelements 12 - aufgrund einer Verlustleistung im Bauelement 12 selbst - führt zu dem Festigkeitsverlust der Lotverbindungen 18, 20. Übersteigt die Kraft der Federeinrichtung 32 die Haltekräfte der Lotverbindungen 18, 20 wird das Bauelement 12 von der Platine abgehoben. Die Abtrennung von einer die Erwärmung hervorrufenden elektrischen Quelle ist erfolgt, somit ist das Bauelement 12 in einen sicheren Zustand überführt. Der sichere Zustand ist dadurch beschrieben, dass eine weitere Erwärmung ausgeschlossen ist und zur Sicherstellung der elektrischen Isolation die elektrischen Verbindungen irreversibel aufgetrennt sind.

Ist die Vorrichtung 30 mit einer Fixierung der Federeinrichtung 32 mittels eines niedrigschmelzenden Kunststoffs ausgeführt, schmilzt zunächst dieser Kunststoff und gibt damit die Federeinrichtung 32 frei kurz bevor die Lotverbindungen aufschmelzen.

Mit Hilfe eines auf Basis intumeszenter Stoffe, eines Formgedächtnismaterials oder einer thermisch aktivierten chemischen Reaktion wirkenden Aktors 34 (hier nicht gezeigt) kann ebenfalls eine Abtrennung herbeigeführt werden. Erwärmt sich der Aktor 34 aufgrund der Bauelemente-Verlustleistung auf seine Aktivierungstemperatur, baut dieser einen Druck auf das Bauelement 12 auf. Außerdem führt die Erwärmung zu einem Festigkeitsverlust der Lotverbindungen 18, 20. Übersteigt die Kraft des Aktors 34 die Haltekraft der Lotverbindungen 18, 20 wird das Bauelement 12 von der Leiterplatte abgehoben. Die Abtrennung von der elektrischen Quelle ist erfolgt, somit ist das Bauelement 12 von der Überlastschutzanordnung 40 in einen sicheren Zustand überführt.

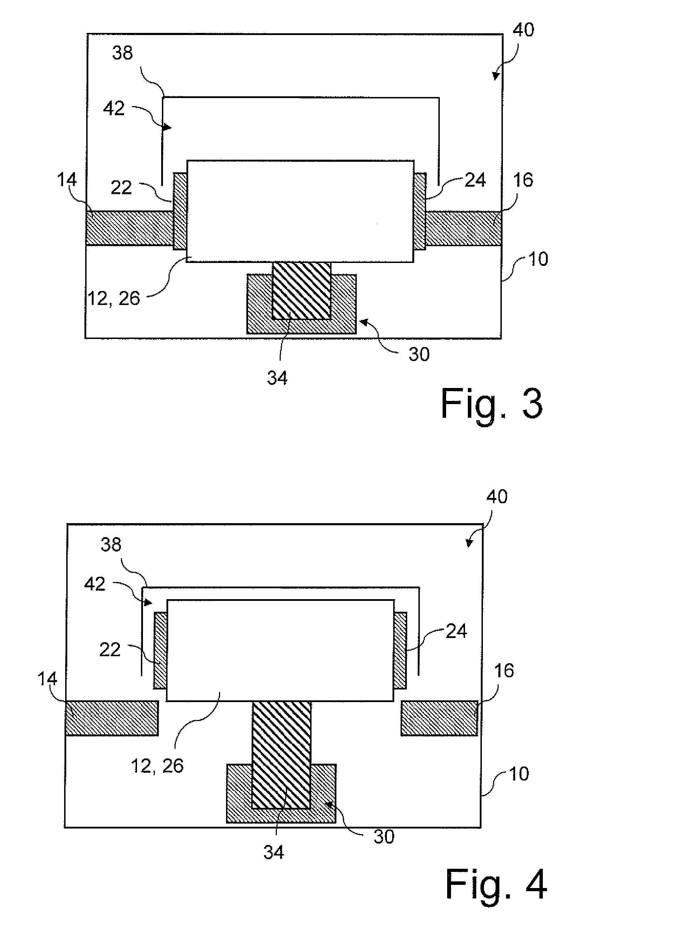

Die in den Figuren 3 und 4 gezeigte Anordnung entspricht im Wesentlichen der Anordnung der Figuren 1 und 2, sodass hier nur auf die Unterschiede eingegangen werden soll.

Die Figuren 3 und 4 zeigen den Ausschnitt der Trägereinrichtung 10 mit oberflächenmontiertem Bauelement 12 (SMD-Bauelement 26) in Draufsicht. Fig. 3 zeigt die Anordnung im Normalbetrieb, Fig. 4 bei ausgelöster Abtrennvorrichtung 30 der Überlastschutzanordnung 40.

Wesentlicher Unterschied zur Anordnung der Figuren 1 und 2 ist die Anordnung von Abtrennvorrichtung 30, Bauelement 12 und Fangeinrichtung 38. Diese sind nun entlang einer gedachten Achse längs der Oberfläche der Trägereinrichtung 10 hintereinander angeordnet. Schmelzen die Lotverbindungen 18, 20 auf, so verlagert die Abtrennvorrichtung 30 das Bauelement 12 zur Separation von den Stromführungselementen 14, 16 im Wesentlichen entlang der Oberfläche der Trägereinrichtung 10, insbesondere quer zu einer gedachten Verbindungslinie zwischen den zwei über das Bauelement 12 elektrisch aneinander gekoppelte Lotverbindungen 18, 20.

### Bezugszeichenliste

- Trägereinrichtung: 10
- Bauelement: 12
- Stromführungselement: 14
- Stromführungselement: 16
- Lotverbindung: 18
- Lotverbindung: 20
- Anschluss: 22
- Anschluss: 24
- SMD-Bauelement: 26
- Ausnehmung: 28
- Abtrennvorrichtung: 30
- Federeinrichtung: 32
- Aktor: 34
- Grundplatte: 36
- Fangeinrichtung: 38
- Überlastschutzanordnung: 40
- Aufnahmebereich: 42

## Patentansprüche

1. Thermische Überlastschutzanordnung (40) zum Schutz eines auf einer Trägereinrichtung (10) mit Stromführungselementen (14, 16) angeordneten elektrischen Bauelements (12), insbesondere elektronischen Bauelements, wobei die Überlastschutzanordnung (40) mehrere, je eines der Stromführungselemente (14, 16) mit einem zugehörigen Anschluss (22, 24) des elektrischen Bauelements (12) elektrisch kontaktierende und bei Überlast des Bauelements (12) schmelzende Lotverbindungen (18, 20) und eine Abtrennvorrichtung (30) zum Lösen mindestens einer dieser Verbindungen (18, 20) aufweist, wobei die Abtrennvorrichtung (30) eine das Bauelement (12) gegenüber der Trägereinrichtung (10) zumindest bei Erwärmung vorspannende Abtrennvorrichtung zur räumlichen Separation des Bauelements (12) von mindestens einem der Stromführungselemente (14, 16) ist, die bei Aufschmelzen der Lotverbindungen (18, 20) auslöst, **dadurch gekennzeichnet, dass** die Abtrennvorrichtung (30) eine Abtrennvorrichtung für ein Verlagern des Bauelements (12) zu dessen Separation von dem mindestens einen Stromführungselement (14, 16) entlang der Oberfläche der Trägereinrichtung (10) ist.

2. Überlastschutzanordnung nach Anspruch 1, wobei die Abtrennvorrichtung (30) einen Aktor (34) aufweist, der als Federeinrichtung (32) und/oder Einrichtung aus intumeszentem Material und/oder Einrichtung aus Formgedächtnismaterial und/oder Einrichtung aus einem seine Form chemisch verändernden Material ausgebildet ist.

3. Überlastschutzanordnung nach einem der vorhergehenden Ansprüche, mit einer Fangeinrichtung (38), die das separierte Bauelement (12) - alleine oder zusammen mit der Abtrennvorrichtung (30) - in einer definierten Position fixiert.

4. Überlastschutzanordnung nach einem der Ansprüche 2 oder 3, wobei der Aktor (34) zwischen zumindest zwei der Lotverbindungen (18, 20) angeordnet ist.

5. Überlastschutzanordnung nach einem der vorhergehenden Ansprüche, wobei die Überlastschutzanordnung (40) das Bauelement (12) und/oder die Trägereinrichtung (10) aufweist.

6. Überlastschutzanordnung nach Anspruch 5, wobei das Bauelement (12) als SMD-Bauelement (26) ausgebildet ist.

7. Überlastschutzanordnung nach Anspruch 6, wobei die Anordnung (40) den als Federeinrichtung (32) ausgebildeten Aktor (34), das SMD-Bauelement (26) und die Lotverbindungen (18, 20) aufweist und als oberflächenmontierbare Anordnung ausgebildet ist.

8. Verfahren zum Schutz eines auf einer Trägereinrichtung (10) mit Stromführungselementen (14, 16) angeordneten elektrischen Bauelements (12), insbesondere elektronischen Bauelements, wobei mehrere, je eines der Stromführungselemente (14, 16) mit einem zugehörigen Anschluss (22, 24) des Bauelements (12) elektrisch kontaktierende und bei Überlast des Bauelements (12) schmelzende Lotverbindungen (18, 20) und eine Abtrennvorrichtung (30) zum Lösen dieser Verbindungen vorgesehen sind, wobei die Abtrennvorrichtung (30) das Bauelement (12) gegenüber der Trägereinrichtung (10) - zumindest bei Erwärmung - vorspannt und das Bauelement (12) bei Aufschmelzen der Lotverbindungen (18, 20) räumlich von den Stromführungselementen (14, 16) separiert, **dadurch gekennzeichnet, dass** die Abtrennvorrichtung (30) das Bauelement (12) zur Separation von dem mindestens einen Stromführungselement (14, 16) entlang der Oberfläche der Trägereinrichtung (10) verlagert.

## Claims

1. A thermal overload protection arrangement (40) for protecting an electrical component (12) arranged on a mounting device (10) having current-carrying elements (14, 16), in particular an electronic component, such that the overload protection arrangement (40) has a plurality of soldered joints (18, 20) which contact one of the current-carrying elements (14, 16) with a respective terminal (22, 24) of an electrical part and which melt when there is an overload on the component (12), and having a separation device (30) for releasing at least one of these joints (18, 20), whereby the separation device (30) is a separation device which prestresses the component (12) with respect to the mounting device (10) at least when there is heating for a spatial separation of the component (12) from at least one of the current-carrying elements (14, 16) which is tripped when the soldered joints (18, 20) are melted, **characterized in that** the separation device (30) is a separation device for shifting the component (12) to separate it from the at least one current-carrying element (14, 16) along the surface of the mounting device (10).

2. The overload protection arrangement according to claim 1, wherein the separation device (30) has an actuator (34) which is designed as a spring mechanism (32) and/or as a device made of intumescent material and/or a device made of a shape memory material and/or a device made of a material which chemically changes its shape.

3. The overload protection arrangement according to any one of the preceding claims, having an arresting device (38) which secures the separated component (12) - alone or together with the separation device (30) - in a defined position.

4. The overload protection arrangement according to any one of claims 2 to 3, wherein the actuator (34) is arranged between at least two of the soldered joints (18,20).

5. The overload protection arrangement according to any one of the preceding claims, wherein the overload protection arrangement (40) has the component (12) and/or the mounting device (10).

6. The overload protection arrangement according to claim 5, wherein the component (12) is designed as an SMD component (26).

7. The overload protection arrangement according to claim 6, wherein the arrangement (40) has the actuator (34) which is designed as a spring mechanism (32), the SMD component (26) and the soldered joints (18, 20) and is designed as a surface mount arrangement.

8. A method for protecting an electrical component (12) arranged on a mounting device (10) having current-carrying elements (14, 16), in particular an electronic component, wherein a plurality of soldered joints (18, 20) which contact one of the current-carrying elements (14, 16) to a corresponding terminal (22, 24) of the component (12) electrically and melt when there is an overload on the component (12) and having a separation device (30) for tripping these joints, such that the separation device (30) prestresses the component with respect to the mounting device (10) - at least when heated - and separate the component (12) spatially from the current-carrying elements (14, 16) when the soldered joints are melted, **characterized in that** the separation device (30) shifts the component (12) to separate it from the at least one current-carrying element (14, 16) along the surface of the mounting device (10).

## Revendications

1. Dispositif de protection thermique contre la surcharge (40) pour la protection d'un élément de construction électrique (12), en particulier un élément de construction électronique, lequel est agencé sur un moyen de support (10) avec des éléments conducteurs de courant (14, 16), le dispositif de protection thermique (40) comportant plusieurs joints soudés (18, 20) fondant lors d'une surcharge de l'élément de construction (12) et mettant respectivement en contact électrique l'un des éléments conducteurs de courant (14, 16) avec un raccord (22, 24) correspondant de l'élément de construction électrique (12), ainsi qu'un dispositif de séparation (30) pour la suppression d'au moins l'un de ces joints (18, 20), le dispositif de séparation (30) étant un dispositif de séparation mettant l'élément de construction (12) sous pré-tension par rapport au moyen de support (10), du moins pendant le chauffage, pour la séparation spatiale de l'élément de construction (12) d'avec au moins l'un des éléments conducteurs de courant (14, 16), lequel se déclenche lors de la fusion des joints soudés (18, 20), **caractérisé en ce que** le dispositif de séparation (30) est un dispositif de séparation pour un déplacement de l'élément de construction (12) en vue de la séparation de celui-ci d'avec l'au moins un élément conducteur de courant (14, 16) le long de la surface du moyen de support (10).

2. Dispositif de protection contre la surcharge selon la revendication 1, dans lequel le dispositif de séparation (30) comporte un acteur (34) conçu comme un moyen à ressort (32) et/ou comme un moyen constitué d'un matériau intumescent et/ou comme un moyen constitué d'un matériau à mémoire de forme et/ou comme un moyen constitué d'un matériau modifiant sa forme chimiquement.

3. Ensemble de protection contre la surcharge selon l'une des revendications précédentes, avec un dispositif de capture (38) fixant l'élément de construction (12) séparé - seul ou ensemble avec le dispositif de séparation (30) - dans une position définie.

4. Ensemble de protection contre la surcharge selon l'une des revendications 2 ou 3, dans lequel l'acteur (34) est agencé entre au moins deux des joints soudés (18, 20).

5. Ensemble de protection contre la surcharge selon l'une des revendications précédentes, dans lequel l'Ensemble de protection contre la surcharge (40) comporte l'élément de construction (12) et/ou le moyen de support (10).

6. Ensemble de protection contre la surcharge selon la revendication 5, dans lequel l'élément de construction (12) est conçu comme un élément de construction SMD (26).

7. Ensemble de protection contre la surcharge selon la revendication 6, dans lequel l'ensemble (40) comporte l'acteur (34) conçu comme un moyen à ressort (32), l'élément de construction SMD (26) et les joints soudés (18, 20), tout en étant conçu comme un ensemble susceptible d'être monté sur une surface.

8. Procédé pour la protection d'un élément de construction électrique (12), en particulier un élément de construction électronique, agencé sur un moyen de support (10) avec des éléments conducteurs de courant (14, 16), dans lequel il est prévu plusieurs joints soudés (18, 20) fondant lors d'une surcharge de l'élément de construction (12) et mettant respectivement en contact électrique l'un des éléments conducteurs de courant (14, 16) avec un raccord (22, 24) correspondant de l'élément de construction électrique (12), ainsi qu'un dispositif de séparation (30) pour la suppression de ces joints, le dispositif de séparation (30) mettant l'élément de construction (12) sous pré-tension par rapport au moyen de support (10) - du moins pendant le chauffage - et séparant spatialement l'élément de construction (12) d'avec les éléments conducteurs de courant (14, 16) lors de la fusion des joints soudés (18, 20), **caractérisé en ce que** le dispositif de séparation (30) déplace l'élément de construction (12) en vue de la séparation d'avec l'au moins un élément conducteur de courant (14, 16) le long de la surface du moyen de support (10).
